# EUROPEAN PATENT APPLICATION

(11) **EP 4 759 974 A2**
(43) Date of publication of application: **17.06.2026**
(21) Application number: 25203235.4
(22) Date of filing: 19.09.2025
(51) Int. Cl.: C30B 23/06, C30B 29/36

(54) **MANAGING GROWTH OF SILICON CARBIDE CRYSTALS**

(30) Priority: 18.11.2024 US 202418951445
(71) Applicant: Semiconductor Components Industries, LLC, Scottsdale, AZ 85250 (US)
(72) Inventor: VALEK, Lukas, 75661 Stritez nad Becvou (CZ); HYBL, Jan, Zubri (CZ); MACKO, Rastislav, 06601 Hummene, Presovsky kraj (SK)
(74) Representative: Manitz Finsterwald Patent- und Rechtsanwaltspartnerschaft mbB

(57) **Abstract**

Silicon carbide substrates are in demand for high power applications such as electric vehicles, solar panels, and industrial electronics. A physical vapor transport (PVT) reactor for growth of silicon carbide ingots can be improved by attaching a cooling assembly to a top end of a PVT growth crucible. By varying the number, size, and spacing of cooling elements within the cooling assembly, radial temperature variation inside the PVT growth crucible can be adjusted, independent of axial temperature variation. More uniform radial temperature profiles result in lower stress, fewer crystal defects, and improved silicon carbide wafer quality.

## Description

### TECHNICAL FIELD

This description relates to a method and apparatus for growing silicon carbide (SiC) crystals for use in the electronics industry. More specifically, this description relates to controlling SiC crystal growth in a physical vapor transport reactor.

### BACKGROUND

Silicon carbide can be used as an alternative substrate material to silicon in the fabrication of integrated circuits. Some useful properties of SiC-based microchips, e.g., metal-oxide-semiconductor field effect transistors (SiC MOSFETs) include reduced weight, low power consumption, and the ability to sustain high temperature operation. Whereas silicon devices operate at temperatures up to about 120 degrees C, SiC devices can operate at temperatures as high as 500 degrees C to 800 degrees C, due to the high thermal conductivity of SiC, which is about 3.5 times greater than that of silicon. SiC devices are therefore particularly suited for high power applications such as electric vehicles (EVs), hybrid electric vehicles (HEVs), solar panels, and industrial applications. In particular, SiC devices have been inserted into EV production in DC-DC converters and on-board fast battery chargers.

### SUMMARY

In some aspects, the techniques described herein relate to an apparatus, including: a reactor configured for crystal growth from a seed crystal; a crucible coupled to an internal wall of the reactor; a heater coupled to an external wall of the reactor; and a cooling assembly coupled to a top end of the crucible, the cooling assembly including: a cooling element; and thermal insulation surrounding the cooling element.

In some aspects, the techniques described herein relate to an apparatus, wherein the cooling element has a ring shape.

In some aspects, the techniques described herein relate to an apparatus, wherein the apparatus further includes a pyrometer, and the cooling assembly further includes a pyrometer viewing port.

In some aspects, the techniques described herein relate to an apparatus, wherein the cooling element is centered around the pyrometer viewing port.

In some aspects, the techniques described herein relate to an apparatus, further including additional cooling elements arranged concentrically around the pyrometer viewing port.

In some aspects, the techniques described herein relate to an apparatus, wherein attributes of the pyrometer viewing port can be varied to control the crystal growth by changing an axial temperature gradient within the reactor.

In some aspects, the techniques described herein relate to an apparatus, wherein attributes of the cooling element can be varied to control the crystal growth by changing a radial temperature gradient within the reactor.

In some aspects, the techniques described herein relate to an apparatus, wherein attributes of the thermal insulation can be varied to control the crystal growth by changing a an axial temperature gradient and a radial temperature gradient within the reactor.

In some aspects, the techniques described herein relate to an apparatus, wherein the crucible includes an isostatic graphite.

In some aspects, the techniques described herein relate to an apparatus, wherein the heater includes an induction coil.

In some aspects, the techniques described herein relate to an apparatus, wherein the thermal insulation includes a soft graphite felt material.

In some aspects, the techniques described herein relate to an apparatus, wherein the reactor is a physical vapor transport reactor.

In some aspects, the techniques described herein relate to a method, including: configuring a reactor with a pyrometer viewing port and a cooling element centered around the pyrometer viewing port; disposing thermal insulation around the cooling element; adjusting an attribute of the cooling element to influence a temperature gradient within the reactor; and adjusting an attribute of the thermal insulation to influence the temperature gradient.

In some aspects, the techniques described herein relate to a method, wherein adjusting an attribute of the cooling element includes adjusting a dimension of the cooling element.

In some aspects, the techniques described herein relate to a method, wherein adjusting an attribute of the cooling element includes adjusting a position of the cooling element.

In some aspects, the techniques described herein relate to a method, wherein adjusting an attribute of the cooling element includes adjusting a number of cooling elements.

In some aspects, the techniques described herein relate to a method, wherein adjusting an attribute of the thermal insulation includes adjusting a material of the thermal insulation.

In some aspects, the techniques described herein relate to a method, wherein adjusting an attribute of the thermal insulation includes adjusting a thickness of the thermal insulation.

In some aspects, the techniques described herein relate to a cooling assembly, including: a pyrometer configured for attachment to a physical vapor transport reactor; a pyrometer viewing port introduced into the thermal insulation of the growth crucible for measurement of crucible temperature by the pyrometer; a cooling element disposed around the pyrometer viewing port; and thermal insulation surrounding the cooling element and the pyrometer viewing port.

In some aspects, the techniques described herein relate to a cooling assembly, wherein the cooling element is centered around the pyrometer viewing port.

In some aspects, the techniques described herein relate to a cooling assembly, wherein: a dimension of the pyrometer viewing port controls a vertical temperature gradient within the physical vapor transport reactor, a dimension of the cooling element controls an axial temperature gradient and a radial temperature gradient within the physical vapor transport reactor, and a dimension of the thermal insulation controls an axial temperature gradient and a radial temperature gradient within the physical vapor transport reactor.

In some aspects, the techniques described herein relate to a cooling assembly, wherein a dimension of the pyrometer controls a vertical temperature gradient within the physical vapor transport reactor, a dimension of the cooling element controls a radial temperature gradient within the physical vapor transport reactor, and a dimension of the thermal insulation controls a radial temperature gradient within the physical vapor transport reactor.

### BRIEF DESCRIPTION OF THE DRAWINGS

FIGs. 1-5 are cross-sectional views of various implementations of a physical vapor transport (PVT) reactor, according to an implementation of the present disclosure.
FIG. 6 is a pictorial top perspective view of the PVT reactor shown in FIGs. 1-5.
FIGs. 7A and 7B show input geometries for a computer model of the PVT reactor shown in FIGs. 1-6, according to an implementation of the present disclosure.
FIG. 8A is a plot of crystal growth rate as a function of distance from the center of the PVT reactor, according to implementations of the present disclosure.
FIG. 8B is a simulated temperature map of a PVT apparatus, corresponding to the input geometry shown in FIG. 7B, according to implementations of the present disclosure.
FIGs. 9A and 9B illustrate various configurations of a cooling assembly and associated temperature maps, according to an implementation of the present disclosure.
FIG. 10 is a flow diagram illustrating a method of forming a SiC boule, according to an implementation of the present disclosure.

Aspects of the present disclosure are best understood from the following detailed description when read with the accompanying figures. It is noted that, in accordance with common practice in the industry, various features are not necessarily drawn to scale. Dimensions of the various features may be arbitrarily increased or reduced for clarity of discussion. In the drawings, like reference symbols may indicate like and/or similar components (elements, structures, etc.) in different views. The drawings illustrate generally, by way of example, but not by way of limitation, various implementations discussed in the present disclosure. Reference symbols shown in one drawing may not be repeated for the same, and/or similar elements in related views. Reference symbols that are repeated in multiple drawings may not be specifically discussed with respect to each of those drawings but are provided for context between related views. Also, not all like elements in the drawings are specifically referenced with a reference symbol when multiple instances of an element are illustrated.

### DETAILED DESCRIPTION

Silicon carbide ingots for use in the fabrication of integrated circuits can be grown in a physical vapor transport (PVT) reactor. A PVT reactor can have the form of a vertical cylindrical chamber, or crucible, that has a seed crystal at one end, e.g., at an upper end. The crucible can receive source materials of silicon and carbon opposite the seed crystal. The source materials are heated until they vaporize. The resulting silicon and carbon gases rise within the crucible, and when the gas encounters the seed crystal, the gas crystalizes around the seed crystal, causing crystal growth radially outward as well as axially outward in a downward direction. Such crystal growth forms a cylindrical boule that can later be sliced into SiC wafers for use as substrates in a semiconductor fabrication process.

Process control during SiC crystal growth in a PVT reactor is challenging. During crystal growth, a vertical temperature gradient creates a driving force for transport and condensation of the gas species present in the crucible. The vertical temperature gradient can be influenced by insulation design, position of the crucible relative to external heaters, and by a pyrometer peephole (also can be referred to as a viewing port) centered at the top of the crucible.

At least one problem that occurs during the process of crystal growth is that temperature gradients or fluctuations in the radial direction can disrupt crystallization, resulting in irregularities or stress-induced defects, e.g., crystal cracking and dislocations in the crystalline structure of the boule, including, for example, basal plane and prismatic dislocations. Such defects can result in cracking and warping of the SiC wafers. One way to minimize defect density within the boule is to tightly control the growth process to maintain a constant growth rate and to limit both axial and radial temperature gradients.

To control temperature gradients and heat flux, heaters are disposed around the sides of the crucible, and coolers can be disposed at the upper end of the crucible. The heaters can be radio frequency (RF) type induction heater coils. The coolers can be in the form of multiple cooling elements arranged concentrically around the pyrometer peephole. Temperature control can be adjusted by modulating power applied to the heaters, and by altering the number of coolers, the types of coolers, and their locations, dimensions, and spacing. Adding the coolers affords an increased level of control over temperature gradients, heat flux, and crystal growth rate that was previously not possible using heaters alone. The use of cooling elements in a PVT crystal growth process is suitable for growing SiC boules of, for example, diameter 150 mm or 200 mm in particular, as well as boules having other diameters, or boules of alternative composition.

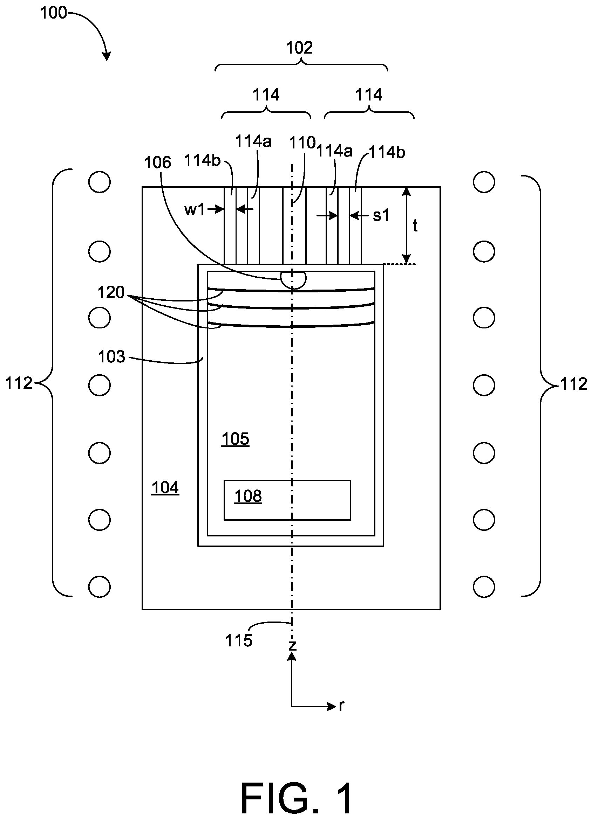

FIGs. 1-5 show cross-sectional views of PVT reactors 100, 200, 300, 400, and 500 configured with cooling assemblies in various arrangements, in accordance with some implementations of the present disclosure.

FIG. 1 illustrates a cross-sectional view of a PVT reactor 100 e.g., a sublimation reactor, configured with a cooling assembly 102, in accordance with some implementations of the present disclosure. In some implementations, the PVT reactor 100, can include an outer chamber wall 103, thermal insulation 104, a growth crucible 105, a seed crystal 106, a hot zone 107, source material 108, a pyrometer 109, and a heater 112.

In some implementations, the growth crucible 105 can be a closed container inside the PVT reactor 100 that defines a growth cell where crystal growth takes place. The growth crucible 105 can be coupled to an internal wall of the PVC reactor 100. The growth cell may be evacuated so that the SiC crystalline boule is grown in a high purity, low pressure environment. In some implementations, the outer chamber wall 103 can be made of quartz, the thermal insulation 104 can be made of low density graphite-based material, and the growth crucible 105 can be made of high density isostatic graphite. Because graphite is highly conductive of both heat and electricity, the graphite material supports inductive heating of the growth crucible 105, surrounding the growth cell.

In some implementations, the thermal insulation 104 can be provided in the form of a thick, soft graphite felt material that wraps around the growth crucible 105, inside the hot zone within the outer chamber wall 103. In some implementations, the thermal insulation 104 can have a thickness in a range of about 3.0 cm to about 8.0 cm. In some implementations, an air gap can separate the outer chamber wall 103 from the thermal insulation 104. In some implementations, a thickness of the air gap can range between about 3 mm and about 7 mm. In some implementations, another inert gas, e.g., argon (Ar) and/or nitrogen gas (N₂), can be substituted for air in the air gap.

Inside the PVT reactor 100, the source material 108 is disposed in a lower region of the growth crucible 105 and the seed crystal 106 is disposed in an upper region of the growth crucible 105.. In some implementations, the SiC seed crystal 106 can be mounted in, e.g., disposed within, a graphite seed module. In some implementations, the seed crystal 106 can be in the form of a SiC wafer having a thickness in a range of about 1 mm to about 2 mm, and a diameter in a range of about 150 mm to about 170 mm.

The source material 108, e.g., a SiC precursor, may be in the form of a powder having a 1:1 ratio of silicon to carbon. As the crucible is heated, the solid SiC source material sublimates to form a gas. The gas rises within the growth cell toward the seed crystal 106, which is at a lower temperature than the gas. When the gas encounters the seed crystal 106, the gas condenses onto the seed crystal 106, causing crystal growth to progress axially downward from the seed crystal 106 in the z-direction. Crystal growth may also expand radially outward, thus enlarging the diameter of the seed crystal 106, and filling some of the surrounding graphite

The pyrometer 109 can be used to sense the temperature of the growth crucible 105. In some implementations, the pyrometer 109 can be attached to one end of the outer chamber wall 103, and aligned with, e.g., centered on, the vertical axis 115.

In some implementations, the heater 112 takes the form of a system of coils, e.g., one or more fixed RF induction coils that wrap around, and are coupled to, e.g., physically coupled to a frame of the PVT reactor 100. The heater 112 thus surrounds sidewalls of the growth crucible 105, where turns of the coil(s) are represented in FIGs. 1-5 by circles. The induction coils of the heater 112 induce electric currents to flow within the growth crucible 105. Power applied to the RF coil(s) can be modulated to control the rate of heating the growth crucible 105, which controls the temperature of the crucible walls. One advantage of induction type heaters is that the heater 112 can remain cooler than the target. In some implementations, the RF coils can reach a temperature of about 90 degrees C, while the temperature of the growth crucible 105 is heated to about 2000 degrees C. In some implementations, the growth crucible 105 can be heated by the heater 112 to a temperature in a range of about 1800 degrees C to about 2500 degrees C. In some implementations, the growth crucible 105 can be positioned with respect to the RF coils so that the temperature of the seed crystal 106 is lower compared to the temperature of the source 108.

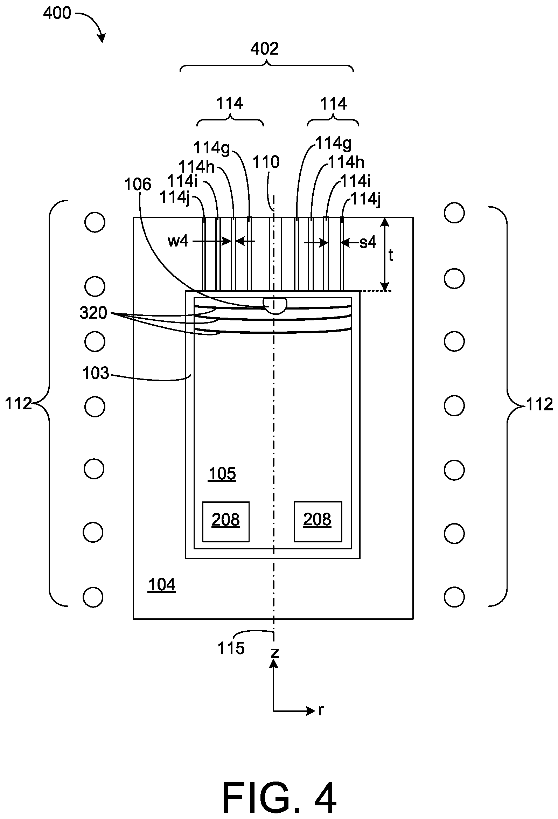

In some implementations, the system of coils of the heater 112 and the pyrometer peephole 110 can be considered as vertical heating elements because they influence temperature gradients in the axial direction. At the same time, the radial temperature gradient is also changed, depending on the parameters of the pyrometer peephole 110 and position of the growth crucible 105 with respect to the induction coils. Therefore, the radial temperature gradient is changed as a function of the vertical temperature gradient. In the examples shown herein, the cooling assembly 102 is a circular cylindrical structure coupled to, e.g., attached to, a top end of the PVT reactor 100, and around (e.g., centered around) a vertical axis 115. In some implementations, the cooling assembly 102 includes a pyrometer peephole 110 and one or more cooling elements 114 (individually labeled as 114 plus a letter (e.g., 114a) and collectively referred to as cooling elements 114). The cooling elements 114 can be separated by additional layers of the thermal insulation 104. The cooling elements 114 can be made of isostatic graphite, in the shape of rings that are axially symmetric about the vertical axis 115, and centered around the pyrometer peephole 110. For example, FIG. 1 shows two such rings, an inner cooling element 114a and an outer cooling element 114b, and FIG. 4 shows four such rings, 114g, 114h, 114i, and 114j. The number of cooling elements 114 can vary, depending on how many cooling elements 114 will fit inside the cooling assembly 102 for a given geometry, and depending on the desired results as described below. In some implementations, the cooling apparatus 102 can include a single cooling element 114. In some implementations, the cooling apparatus 102 can include more than the number of cooling elements 114 shown in FIG. 1.

In some implementations, the cooling elements 114 can be made of a different solid material having thermal conductivity that exceeds the thermal conductivity of the surrounding thermal insulation 104. In some implementations, one or more of the cooling elements 114 can be formed simply by an area of missing thermal insulation 104. In some implementations, horizontal cross-sections of the cooling assembly 102 can have shapes other than circular, e.g., oval, square, rectangular, and so on. In some implementations, the cooling elements 114 can be in the shape of vertical rods instead of rings.

In some implementations, the pyrometer peephole 110 is disposed at the center of the cooling assembly 102, in alignment with the pyrometer 109, to facilitate use of the pyrometer 109 in measuring temperature. In some implementations, the pyrometer peephole 110 can be introduced, e.g., inserted, through the thermal insulation 104 on top of the growth crucible 105. When multiple cooling elements 114 are present, the cooling elements 114 can be arranged concentrically around the pyrometer peephole 110. For example, as shown in at least FIG. 1, cooling element 114a is concentrically disposed within cooling element 114b (e.g., within the same plane, when viewed from above or below). A dimension, e.g., a diameter, of the pyrometer peephole 110 can be adjusted to influence and/or control a vertical, e.g., axial, temperature gradient within the growth crucible 105. As the diameter of the pyrometer peephole 110 is adjusted, the radial temperature gradient is also changed simultaneously with the vertical temperature gradient, which can be detrimental to crystal growth.

In some implementations, while the heater 112 is disposed outside the chamber, the cooling assembly 102 that includes the cooling elements 114 can be disposed inside the outer chamber wall 103, e.g., inside the hot zone 107. In some implementations, the cooling elements contribute to the vertical temperature gradient, and simultaneously control the radial temperature gradient. The pyrometer peephole 110 and the cooling elements 114 can be adjusted to provide the same axial temperature gradient as the pyrometer peephole 110 would provide without the coolers, but using the coolers enables control of the radial temperature. gradient. Use of both the pyrometer peephole 110 and the cooling elements 114 permits setting axial and radial temperature gradients independently of each other.

FIG. 1 further illustrates isotherms 120, which are surfaces of constant temperature. A degree of curvature of each isotherm 120 indicates radial, or center-to-edge, variation in temperature, wherein the temperature is higher at the edge, and lower at the center, of the growth crucible 105. Flat isotherms correspond to a uniform temperature across the growth cell. A radial temperature gradient, or flatness of the isotherms 120, can be expressed as ΔTᵣ / L, or the temperature variation per unit length in the radial direction. Spacing between the isotherms 120 along the z-axis indicates axial, or vertical, temperature variation. Narrow spacing between the isotherms 120 indicates a steep vertical temperature gradient, while wide spacing between the isotherms 120 indicates a gradual vertical temperature gradient. An axial temperature gradient, or spacing between the isotherms 120, can be expressed as ΔTᵥ / L, or the temperature variation per unit length in the vertical (+/-z) direction. Three isotherms are shown as examples in each of FIGs. 1-5, to represent a localized portion of the vertical temperature profile in the vicinity of the seed crystal 106.

In some implementations, the cooling elements 114 can be positioned prior to beginning a process of crystal growth. Additionally or alternatively, the cooling elements 114 can be re-positioned at various times during the process of crystal growth. In some implementations, the growth process for a full SiC ingot can occur over a time interval of about 10 days to about three weeks, in contrast to silicon ingots that can be fully formed in about 1-2 days. In some implementations, the SiC boule can withstand about +/- 1 degree of temperature variation during the crystal growth process.

Crystal growth at the surface of the seed crystal 106 proceeds in a vertical direction at a rate that varies with radial position. The radial profile of the crystal growth rate in the growth crucible 105 depends on temperature, radial temperature gradient, and pressure inside the growth cell. The chamber pressure inside the growth cell can be in the range of, for example, about 0.1 Torr to about 50 Torr. Use of the cooling elements 114 can improve control of radial temperature gradients to maintain a stable radial profile according to the radial growth rate of the crystal and can limit radial variation of the electrical resistivity of the boule to produce SiC wafers with excellent center-to-edge uniformity.

A combination of the pyrometer peephole 110, the heater 112 and the cooling elements 114 can provide control of axial temperature gradients along the z-axis, between the source material and the seed crystal. Control of axial temperature gradients can help maintain a stable axial growth rate of the crystal, resulting in a taller ingot. Control of axial temperature gradients can also limit axial variation of the electrical resistivity of the boule to produce SiC wafers with a low wafer-to-wafer variation. Control of axial temperature gradients can also help maintain a convex crystal-gas interface shape to reduce defects, e.g., dislocations, within the boule to ensure growth of a high quality boule.

The cooling elements 114 can act as heat sinks for heat from the center of the growth crucible 105. The temperature distribution within the crucible, e.g., the shapes of the isotherms 120, can be altered, or tuned, by changing the number, position, dimensions, and spacing of the cooling elements 114. For example, to create a uniform radial temperature distribution corresponding to flat isotherms, heat flux in the center of the crucible can be suppressed relative to heat flux at the edges of the crucible. In some implementations, the isotherms 120 can be flattened by adding more cooling elements 114. In some implementations, influence over, or control of, radial temperature gradients can be achieved by adjusting an attribute, e.g., a position or a dimension, of the cooling element 114, for example, adjusting a width w of the cooling elements 114, a thickness t of the cooling elements 114, and/or a spacing s between adjacent cooling elements 114, e.g., a separation distance between the inner cooling element 114a and the outer cooling element 114b. In some implementations, control of radial temperature gradients can be achieved by adjusting an attribute, e.g., a material, of the thermal insulation 104, or by adjusting a dimension, e.g., a thickness, of the thermal insulation 104. In some implementations, cooling elements 114 within a particular cooling assembly 102 can have similar widths and/or similar spacings, as shown in the figures. In some implementations, cooling elements 114 within a particular cooling assembly 102 can have different widths, and/or different spacings. In some implementations, widths of different cooling elements 114 in a particular cooling assembly 102 can match, while spacings vary. In some implementations, spacings between adjacent cooling elements within a cooling assembly 102 can match, while the widths of the cooling elements vary

In some implementations, the pyrometer peephole 110 also serves as a cooling element, e.g., a central cooling element 114, by extracting heat faster in the +z axial direction than the heat would otherwise dissipate radially through the thermal insulation 104. Thus, the pyrometer peephole 110 and the cooling elements 114 together can be used to control heat flux in the +z direction.

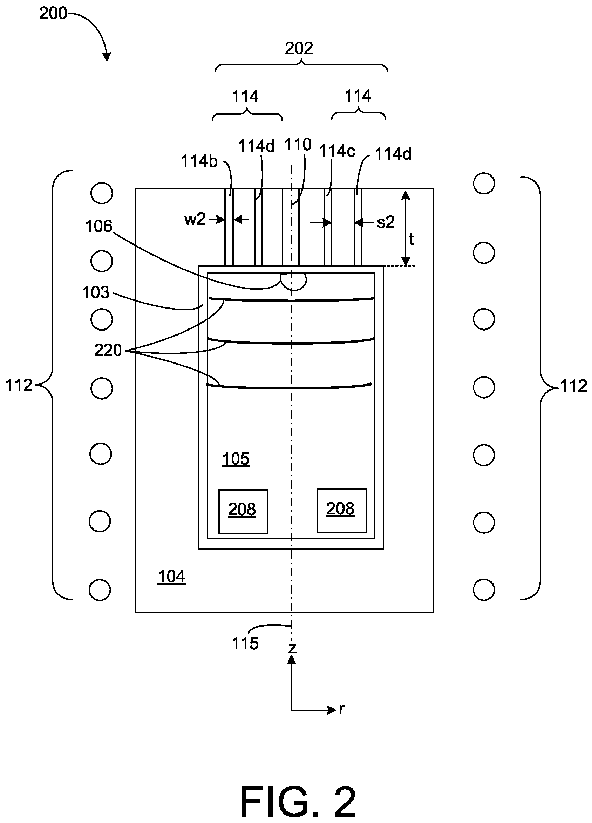

FIGs. 2-5 show four additional examples of configurations for the cooling assembly 102 attached to a PVT reactor, in accordance with some implementations of the present disclosure. Each figure shows a different configuration of cooling elements 114 along with isotherms produced by that configuration.

FIG. 2 illustrates a PVT reactor 200 configured with a cooling assembly 202. The cooling assembly 202 includes two ring-shaped cooling elements 114c and 114d, in accordance with some implementations of the present disclosure. The cooling assembly 202, configured as shown in FIG. 2, can produce isotherms 220. The cooling elements 114c and 114d have narrower widths w2 than the widths w1 of the cooling elements 114a and 114b of the cooling assembly 102 shown in FIG. 1. Consequently, the cooling elements 114c and 114d have wider spacing s2 than the spacing between the cooling elements 114a and 114b. As a result, the isotherms 220 in the growth cell of the PVT reactor 200 exhibit a higher degree of curvature and are spaced farther apart than the isotherms 120 in the PVT reactor 100.

FIG. 2 further illustrates a ring-shaped source material 208, which may differ from the source material 108 shown in FIG. 1. The source material 108 resembles a block as opposed to a ring. The source materials 108 and 208 are interchangeable, and are not observed to affect the isotherms 120 or 220. The pyrometer peephole 110 is unchanged in the configuration shown in FIG. 2.

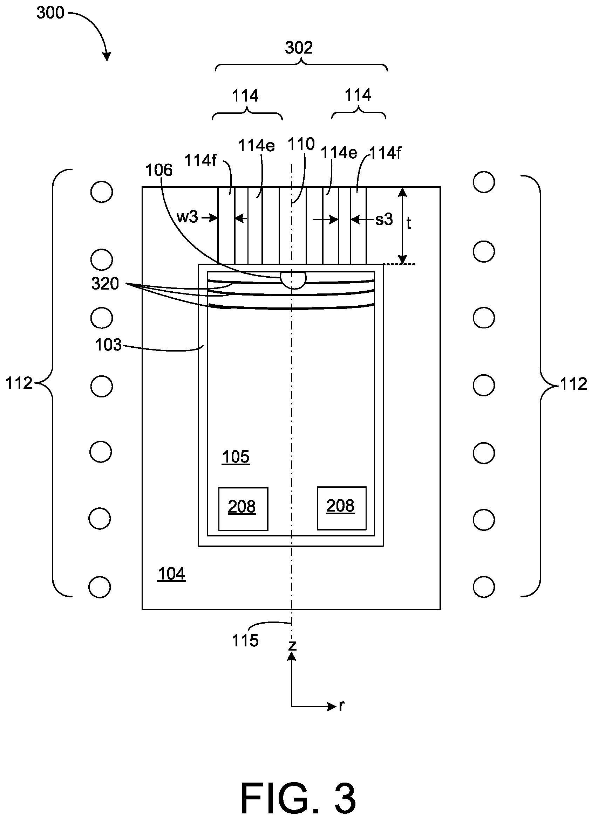

FIG. 3 illustrates a PVT reactor 300 configured with a cooling assembly 302, in accordance with some implementations of the present disclosure. The cooling assembly 302 includes two ring-shaped cooling elements 114e and 114f. The two ring-shaped cooling elements 114e and 114f, configured as shown in IG. 3, can produce isotherms 320. The cooling elements 114e and 114f have wider widths w3 than the widths w1 of the cooling elements 114a and 114b on the PVT reactor 100 shown in FIG. 1. Consequently, the cooling elements 114e and 114f have a narrower spacing s3 than the spacing s1 between the cooling elements 114a and 114b. As a result, the isotherms 320 in the growth cell of the PVT reactor 300 are flatter than the isotherms 120. The isotherms 320 are also spaced closer together than the isotherms 120 in the PVT reactor 100.

FIG. 4 illustrates a PVT reactor 400 configured with a cooling assembly 402, in accordance with some implementations of the present disclosure. The cooling assembly 402 includes four ring-shaped cooling elements 114g 114h, 114i, and 114j. The four ring-shaped cooling elements 114g, 114h, 114i, and 114j, configured as shown in FIG. 4, can produce isotherms 320, that is, substantially the same isotherms as the PVT reactor 300 that is configured with the cooling assembly 302 having only two cooling elements. The cooling elements 114g 114h, 114i, and 114j have narrower widths w4 than any of the widths w1, w2, or w3 of the coolers in the PVT reactors 100, 200, and 300, respectively. Consequently, the cooling elements 114g 114h, 114i, and 114j have a wider spacing s4 than the spacing between any of the coolers in the PVT reactors 100, 200, and 300, respectively. FIGs. 3 and 4 demonstrate that there can exist multiple configurations of cooling elements 114 that can yield substantially equivalent isotherms.

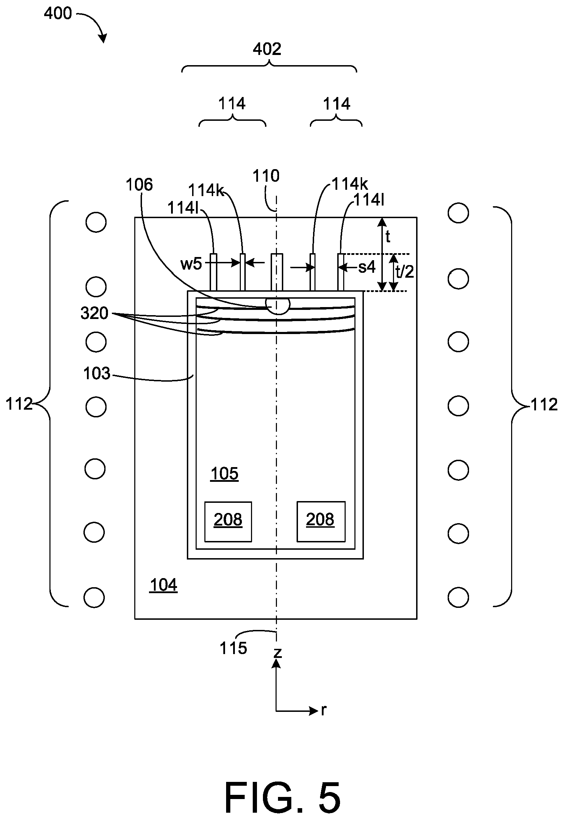

FIG. 5 illustrates a PVT reactor 500 configured with a cooling assembly 502, in accordance with some implementations of the present disclosure. The cooling assembly 502 includes two ring-shaped cooling elements 114k and 1141. The two ring-shaped cooling elements 114k and 1141, configured as shown in FIG. 5, can produce isotherms 320, that is, substantially the same isotherms as the PVT reactor 300 and the PVT reactor 400 that are configured with different cooling assemblies. The cooling elements 114k and 1141 have narrow widths w5 similar to the narrow widths w4 of the cooling elements 114g, 114h, 114i, and 114j on the PVT reactor 400 shown in FIG. 4. However, because the PVT reactor 500 has only two of the narrow coolers, the spacing s5 between the cooling elements 114k and 1141 is wider than any of the other spacings s1, s2, s3, and s4. Another difference between the cooling assembly 502 and the previous examples shown in FIGs. 2-4 is that, because the cooling assembly 502 has a thickness of t/2, the cooling elements 114k and 1141 are therefore only half as tall as the other cooling elements 114a-114j. However, the thickness t of the thermal insulation 104 above the top of the outer chamber wall 103 is the same as in the previous examples shown in FIGs. 1-4, so that the cooling elements 114k and 1141 are uniquely insulated on all sides. FIG. 5 further demonstrates that there can exist multiple configurations of cooling elements 114 that produce substantially equivalent isotherms. In other examples, the thickness (or height) of the cooling assembly can take on other values, e.g., 1.5t, t/2, t/4, and so on, such that the height of the cooling elements 114 may vary accordingly.

Any combination of the elements shown in FIGs. 1 through 5 can be combined in any combination. In some implementations, the sizes for the cooling elements 114 can vary along direction r (e.g., increase from inside to outside, decrease from inside to outside, increase then decrease from inside to outside, decrease then increase from inside to outside, etc.). In some implementations, spacing between cooling elements 114 can vary along direction r (e.g., increase from inside to outside, decrease from inside to outside, increase then decrease from inside to outside, decrease then increase from inside to outside, etc.).

For example, the cooling element 114c in FIG. 2 can be replaced with the cooling element 114e shown in FIG. 3. In other words, a width of the cooling element 114c can be larger than a width of the cooling element 114d shown in FIG. 3. In such implementations, the spacing between cooling elements can be the same or different along the direction r.

As another example, the cooling element 114d in FIG. 2 can be replaced with the cooling element 114f shown in FIG. 3. In other words, a width of the cooling element 114c can be smaller than a width of the cooling element 114d shown in FIG. 3. In such implementations, the spacing between cooling elements 114 can be the same or different along the direction r.

As yet another example, the cooling elements 114i and/or 114h can be larger than or smaller than the cooling elements 114g and/or 114j shown in FIG. 4. In such implementations, the spacing between cooling elements can be different along the direction r. In some implementations, the spacing between cooling elements can be the same along the direction r.

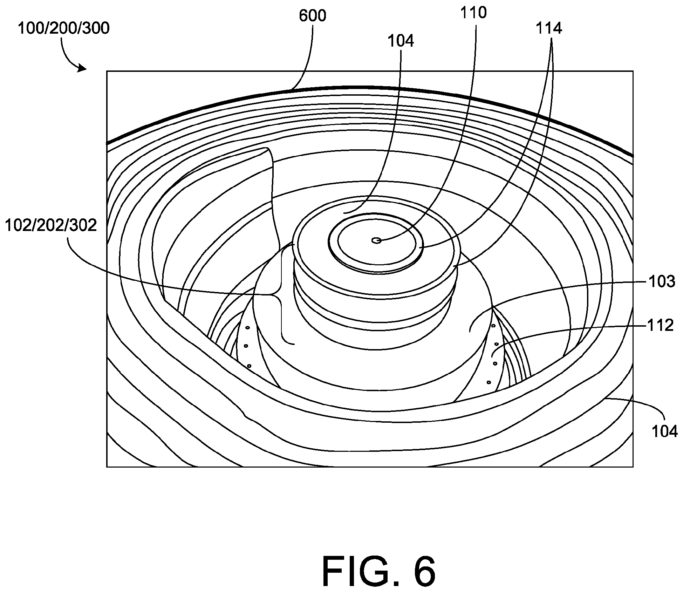

FIG. 6 is a pictorial top perspective view illustrating an example of a hot zone 107 surrounded by the outer thermal insulation 104, in accordance with some implementations of the present disclosure. The hot zone 107 as shown in FIG. 6 is configured with a cooling assembly that includes two ring-shaped cooling elements 114, illustrating the hot zones 107 inside the PVT reactors 100, 200, or 300. In FIG. 6, the outer thermal insulation 104 surrounding the growth chamber has been cut away to reveal the structure of the hot zone 107. The cutaway view also shows layers of the outer thermal insulation 104 that wrap around the growth crucible 105 like a blanket. FIG. 6 shows the growth crucible 105 of the hot zone 107 configured with two ring-shaped cooling elements 114. The cooling elements 114 are disposed on top of growth crucible 105, and extend to the full height of the thermal insulation 104. At the center is the pyrometer peephole 110. In some implementations, a central cooling rod can be used in place of the pyrometer peephole 110. FIG. 6 further illustrates a quartz basket 600 that can be used to contain the outer thermal insulation 104.

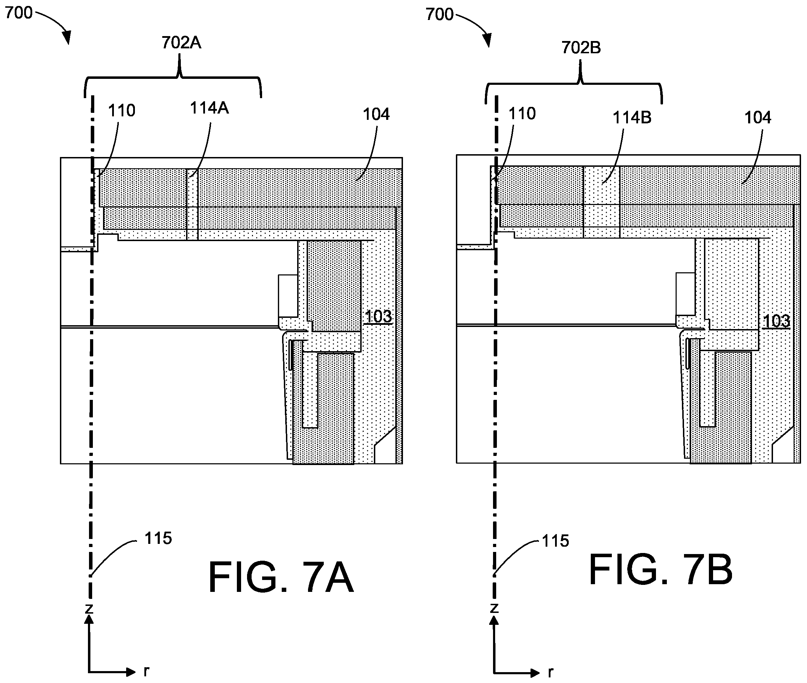

FIGs. 7A, 7B, 8A, 8B, 9A, and 9B pertain to a computer model of a PVT reactor configured with a cooling assembly, in accordance with some implementations of the present disclosure. The computer model simulates SiC crystal growth and the temperature response to the use of the cooling assembly in combination with the heater 112.

FIGs. 7A and 7B are inputs to a computer simulation of a PVT reactor 100, in accordance with some implementations of the present disclosure. FIGs. 7A and 7B illustrate adjustment of a radial growth rate profile of the crystalline boule from the seed crystal 106. The growth rate can be adjusted by varying the power applied to the heater 112, and by modifying the configuration of the cooling assembly used in the PVT reactor 100, that is, by changing the cooling element(s) 114. FIGs. 7A and 7B show a cross-sectional view of the right side of the PVT reactor 100 for two different sets of input conditions.

FIG. 7A shows a cross-sectional view of the right hand side of the PVT reactor 100 for a first set of input conditions, in which a) a power level of 11 kW is applied to the heater 112 (not shown), and b) the PVT reactor 100 is configured with a cooling assembly 702A.the cooling assembly 702A includes a pyrometer peephole 110 and a single narrow ring-shaped cooling element 114A.

FIG. 7B shows a cross-sectional view of the right side of the PVT reactor 700 for a second set of input conditions, in which (a) a power level of 16 kW is applied to the heater 112, and (b) the PVT reactor 100 is configured with a cooling assembly 702B. The cooling assembly 702B includes a pyrometer peephole 110 and a single wide ring-shaped cooling element 114B..

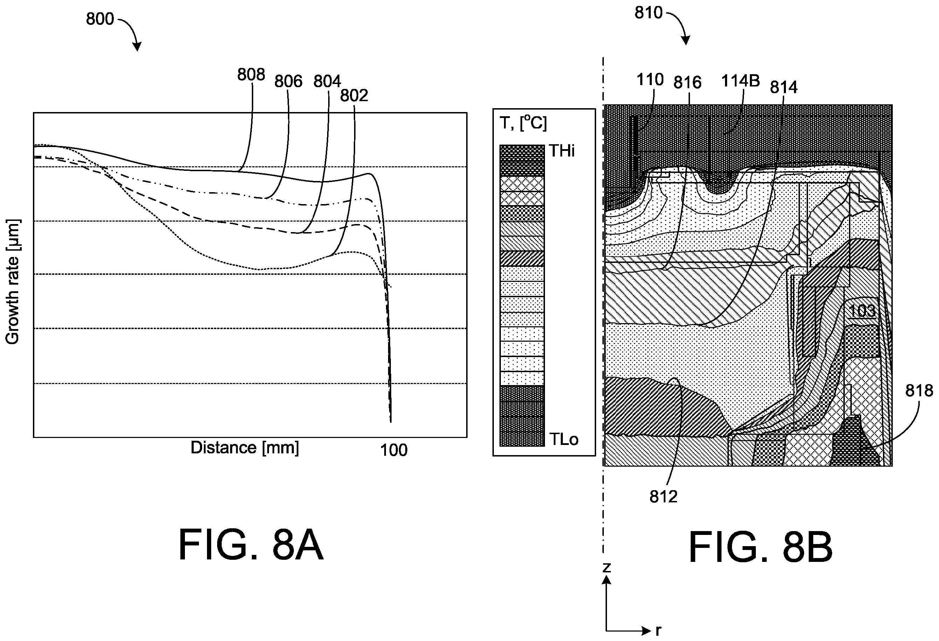

FIGs. 8A and 8B are examples of the output of the computer simulation corresponding to the input conditions specified in FIG. 7B, in accordance with some implementations of the present disclosure.

FIG. 8A is a map 810 showing the radial crystal growth rate per unit time, for an ingot having a radius of 200 mm, as a function of the cooler configuration. Four different growth rate profiles are shown: 802, 804, 806, and 808. The growth rate profile 802 corresponds to cooling assembly 702A; the growth rate profile 808 corresponds to cooling assembly 702B; and the growth rate profiles 804 and 806 correspond to other cooling assemblies (not shown), having sizes between those of the cooling assembly 702A and the cooling assembly 702B. The temperature field shown in FIG. 8B ranges from a minimum temperature T lo between about 2000 degrees C and 2010 degrees C to a maximum temperature T hiᵢ between about 2300 degrees C and about 2320 degrees C. FIG. 8A shows that the crystal growth rate is nearly constant in the center, determined by the pyrometer peephole 110 of constant diameter. In the region below the cooling element 114, the growth rate depends on the size of the cooling element. Thus, the cooler configuration can be changed to modify the radial profile of the growth rate, in this case even without changing the net growth rate in the center.

FIG. 8B shows a simulated temperature map, e.g., a two-dimensional temperature contour plot, superimposed onto the cross-sectional view of the PVT reactor configured as shown in FIG. 7B. The contour plot shows temperature variation within the PVT reactor 700, when configured with the cooling assembly 700B. FIG. 8B shows that the coolest regions of the PVT reactor 700 are indeed in the vicinity of the pyrometer peephole 110 and the cooling element 114B. The hottest region is closest to the heater 112 and the source material being heated, e.g., the outer region of the lower portion of the growth crucible 105. The effect on temperature gradients of the cooling element 114B is to flatten the radial contours of temperature, e.g., the isotherms 814 and 816 in the growth crucible 105, away from the outer chamber wall 103.

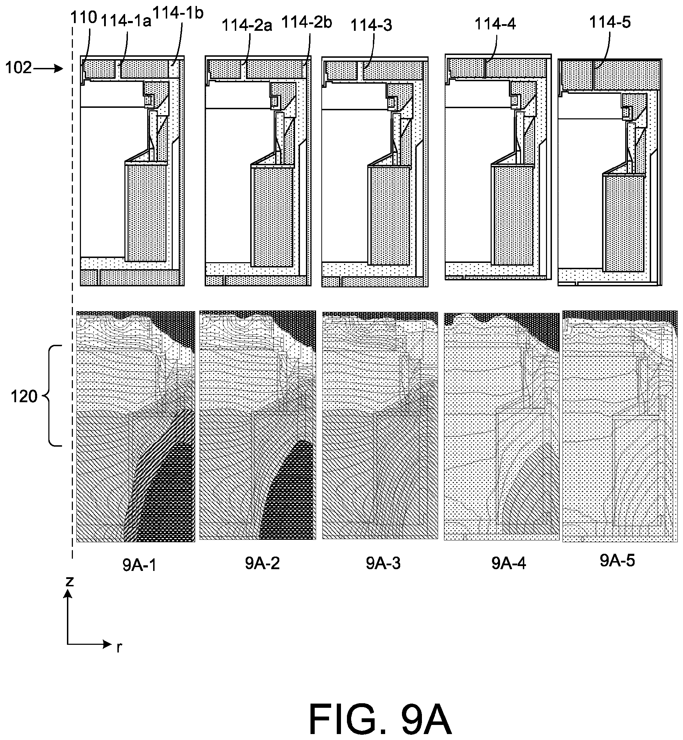

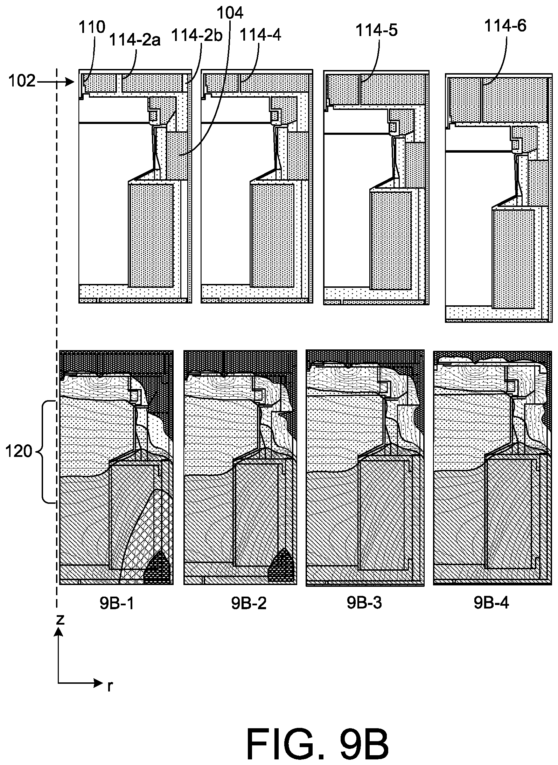

FIGs. 9A and 9B show two series of simulation inputs and corresponding outputs for the PVT reactor 100, in accordance with some implementations of the present disclosure. The simulations show examples of how to shape the temperature field within the PVT reactor 100 using different configurations of the cooling assembly 102. The top panels of FIGs. 9A and 9B, respectively, show various configurations 9A-1, 9A-2...9A-5, and 9B-1...9B-4 for the cooling assembly 102 similar to the configurations shown in FIGs. 7A and 7B, e.g., cooling assembly 702A and cooling assembly 702B; the bottom panels of FIGs. 9A and 9B show simulated temperature maps that the various cooling assembly configurations produce.

In FIG. 9A, the configuration 9A-1 shows a cooling assembly 102 in the top panel that includes the pyrometer peephole 110 and a pair of ring-shaped cooling elements 114-1a and 114-1b, centered around the pyrometer peephole 110. With this configuration, a high power level of 22 kW can be applied to the heater 112 to achieve a desired axial temperature gradient. The temperature map shown in the bottom panel 9A-1 is produced. The high power level produces a hot spot in the lower right corner of the temperature map in the lower panel corresponding to the configuration 9A-1. The edge cooling element 114-1b produces a cool spot at the upper right corner of the temperature map for the configuration 9A-1. The central part of the temperature map for the configuration 9A-1 shows substantially flat isotherms 120.

In the configuration 9A-2, the cooling element 114-2b has a reduced width. Consequently, a reduced power level of 18 kW is applied to the heater 112 while the vertical spacing and flatness of the isotherm in the central region remain essentially unchanged. Reduction of the 114-1 width does not affect the temperature field in the central region.

In the configuration 9A-3, only one cooling element is used, 114-3. The power needed for the desired vertical temperature gradient has dropped to a level of 13 kW applied to the heater 112. Consequently, the lower right corner of the temperature map for the configuration 9A-2 shows a further reduced hot spot compared with the configuration 9A-2. As a result, the cool spot has disappeared from the upper right corner of the temperature map. The vertical spacing and flatness of the isotherm in the central region remain essentially unchanged. Elimination of the 114-2 cooling element does not affect the temperature field in the central region and, as a benefit, reduces the heater power.

In the configuration 9A-4, the vertical temperature gradient is reduced by reducing the thickness of the cooling element 114-3. The power level of the heater 112 drops to 11 kW as a consequence of the associated reduction of the heat flux. The isotherms 120 for the configuration 9A-4 are spaced farther apart, while still being substantially flat. Control of the vertical temperature gradient essentially independent of the radial temperature gradient is demonstrated.

In the configuration 9A-5, the thickness of the top insulation 104 is increased and dimensions of the cooling element 114 are adjusted to maintain the shape and distance of the isotherms in the central region. A low power level of only 9.5 kW is applied to the heater 112. Consequently, the temperature map for the configuration 9A-5 shows no hot spot. As a result, a substantially uniform cool region appears at the top edge of the temperature map for the configurations 9A-5 Otherwise, the temperature map for the configuration 9A-5 shows a substantially uniform temperature. In addition, isotherms 120 for the configuration 9A-5 have maximum spacing, while still being substantially flat. The temperature map for the configuration 9A-5 represents a maximum temperature difference of ΔT = 31 C. The ability to adjust the temperature field and simultaneously optimize process efficiency is demonstrated.

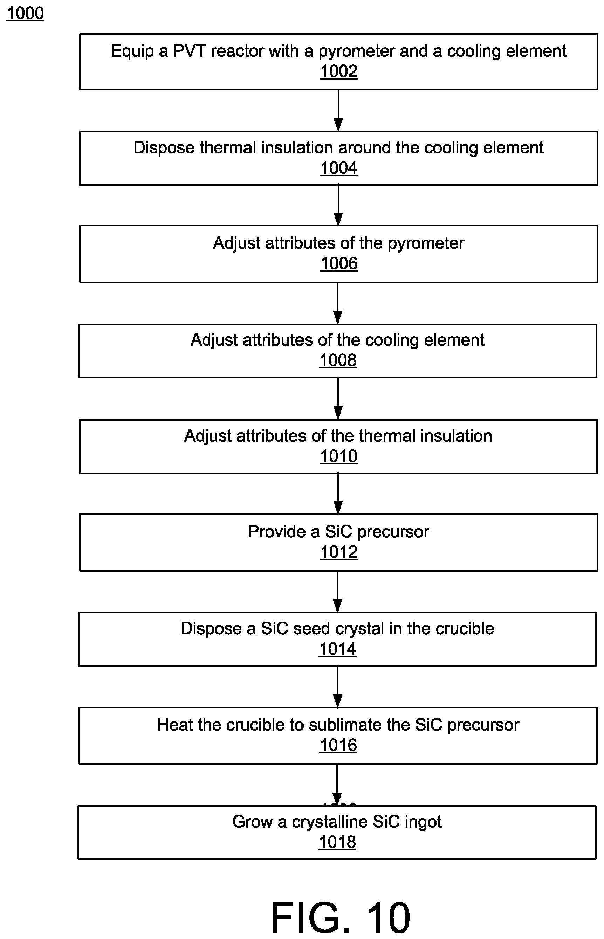

FIG. 10 is a flow chart illustrating a method 1000 of forming a SiC boule in accordance with some implementations of the present disclosure. Operations 1002-1016 of the method 1000 can be carried out to form the SiC boule, according to some implementations as described above with reference to FIGs. 1-5, 6, 7A, 7B, 8A, 8B, 9A, and 9B. Operations of the method 1000 can be performed in a different order, or not performed, depending on specific applications. It is noted that the method 1000 may not completely form a SiC boule. Accordingly, it is understood that additional processes can be provided before, during, or after method 1000, and that some of these additional processes may be briefly described herein.

At 1002, the method 1000 includes providing a PVT reactor with a pyrometer, and a cooling assembly that includes one or more of the cooling elements 114. The method 1000 further includes providing a hot zone, e.g., the hot zone 107, with the pyrometer peephole 110.

At 1004, the method 1000 includes disposing insulation, e.g., the thermal insulation 104, around the cooling elements 114.

At 1006, the method 1000 includes adjusting attributes of the pyrometer peephole 110. Attributes of the pyrometer peephole 110 can be varied to control crystal growth by changing an axial temperature gradient within the PVT reactor 100.

At 1008, the method 1000 includes adjusting attributes of the cooling elements 114. Varying attributes such as the positions, number, and widths of the cooling elements 114, or the spacing between the cooling elements 114, can help to influence or control crystal growth by changing an axial temperature gradient and a radial temperature gradient within the PVT reactor 100.

At 1010, the method 1000 includes adjusting attributes of the thermal insulation 104, e.g., varying a dimension, e.g., a thickness, of the thermal insulation 104, and/or the structure or materials used for the thermal insulation 104. Varying attributes of the thermal insulation 104, can help influence or control crystal growth by changing a radial temperature gradient within the PVT reactor 100.

At 1012, the method 1000 includes providing a crucible, e.g., the growth crucible 105, containing a SiC precursor., e.g., the source material 108.

At 1014, the method 1000 includes disposing a SiC seed crystal, e.g., the seed crystal 106, in a seed module suspended in an upper region of the PVT reactor 100.

At 1016, the method 1000 includes heating the growth crucible 105 to sublimate the SiC precursor, using the heater 112. In some implementations, a temperature range suitable for initiating and sustaining crystal growth is in a range of about 2000C to about 2300C.

At 1018, the method 1000 includes growing a crystalline SiC ingot, using the heater 112 and the cooling elements 114 to control temperature gradients during the growth process. Axial temperature gradients can be controlled using the pyrometer peephole 110, the cooling elements 114, and the thermal insulation 104. Radial temperature gradients can be controlled using the thermal insulation 104 and the cooling elements 114. Use of the cooling elements 114 during the growth process can result in an ingot with a lower defect density and less stress than can be obtained without the use of coolers.

As described above, the addition of cooling elements to a PVT system can assist in controlling SiC crystal formation. The benefits of tighter process control are obtained by decoupling and reducing axial and radial temperature variation in a growth cell of the PVT chamber. By altering the geometry of cooling rings applied to a top outside surface of the PVT growth crucible, radial temperature profiles inside the PVT growth crucible can be controlled separately from axial temperature profiles.

It will be understood that, in the foregoing description, when an element, such as a layer, a region, or a substrate, is referred to as being on, connected to, electrically connected to, coupled to, or electrically coupled to another element, it may be directly on, connected or coupled to the other element, or one or more intervening elements may be present. In contrast, when an element is referred to as being directly on, directly connected to or directly coupled to another element or layer, there are no intervening elements or layers present. Although the terms directly on, directly connected to, or directly coupled to may not be used throughout the detailed description, elements that are shown as being directly on, directly connected or directly coupled can be referred to as such. The claims of the application may be amended to recite exemplary relationships described in the specification or shown in the figures.

As used in this specification, a singular form may, unless definitely indicating a particular case in terms of the context, include a plural form. Spatially relative terms (e.g., over, above, upper, under, beneath, below, lower, top, bottom, and so forth) are intended to encompass different orientations of the device in use or operation in addition to the orientation depicted in the figures. In some implementations, the relative terms above and below can, respectively, include vertically above and vertically below. In some implementations, the term adjacent can include laterally adjacent to or horizontally adjacent to.

Some implementations may employ various semiconductor processing and/or packaging techniques. Some implementations may use various types of semiconductor device processing techniques associated with semiconductor substrates including, but not limited to, for example, silicon (Si), silicon carbide (SiC), gallium arsenide (GaAs), gallium nitride (GaN), and/or so forth.

While certain features of the described implementations have been illustrated as described herein, many modifications, substitutions, changes, and equivalents will now occur to those skilled in the art. For instance, features illustrated with respect to one implementation can, where appropriate, also be included in other implementations. It is, therefore, to be understood that the appended claims are intended to cover all such modifications and changes as fall within the scope of the implementations. It should be understood that they have been presented by way of example only, not limitation, and various changes in form and details may be made. Any portion of the apparatus and/or methods described herein may be combined in any combination, except mutually exclusive combinations. The implementations described herein can include various combinations and/or sub-combinations of the functions, components and/or features of the different implementations described.

## Claims

1. An apparatus, comprising:
a reactor configured for crystal growth from a seed crystal;
a crucible coupled to an internal wall of the reactor;
a heater coupled to an external wall of the reactor; and
a cooling assembly coupled to a top end of the crucible, the cooling assembly including:
a cooling element; and
thermal insulation surrounding the cooling element.

2. The apparatus of claim 1 or the cooling assembly of claim 15, wherein the cooling element has a ring shape.

3. The apparatus of claim 1, wherein the apparatus further comprises a pyrometer, and the cooling assembly further comprises a pyrometer viewing port.

4. The apparatus of claim 3 or the cooling assembly of claim 15, wherein the cooling element is centered around the pyrometer viewing port.

5. The apparatus of claim 3 or the cooling assembly of claim 15, further comprising additional cooling elements arranged concentrically around the pyrometer viewing port.

6. The apparatus of claim 3, wherein attributes of the pyrometer viewing port can be varied to control the crystal growth by changing an axial temperature gradient within the reactor.

7. The apparatus of claim 1, wherein attributes of the cooling element can be varied to control the crystal growth by changing a radial temperature gradient within the reactor.

8. The apparatus of claim 1, wherein attributes of the thermal insulation can be varied to control the crystal growth by changing an axial temperature gradient and a radial temperature gradient within the reactor.

9. The apparatus of claim 1, wherein the crucible includes an isostatic graphite.

10. The apparatus of claim 1, wherein the thermal insulation includes a soft graphite felt material.

11. The apparatus of claim 1, wherein the reactor is a physical vapor transport reactor; and wherein the heater includes an induction coil.

12. A method, comprising:
configuring a reactor with a pyrometer viewing port and a cooling element centered around the pyrometer viewing port;
disposing thermal insulation around the cooling element;
adjusting an attribute of the cooling element to influence a temperature gradient within the reactor; and
adjusting an attribute of the thermal insulation to influence the temperature gradient.

13. The method of claim 12, wherein adjusting an attribute of the cooling element includes at least one of:
adjusting a dimension of the cooling element;
adjusting a position of the cooling element;
adjusting a number of cooling elements;
adjusting a material of the thermal insulation; and
adjusting a thickness of the thermal insulation.

14. A cooling assembly, comprising:
a pyrometer configured for attachment to a physical vapor transport reactor;
a pyrometer viewing port introduced into thermal insulation of a growth crucible for measurement of crucible temperature by the pyrometer;
a cooling element disposed around the pyrometer viewing port; and
thermal insulation surrounding the cooling element and the pyrometer viewing port.

15. The cooling assembly of claim 14, wherein:
a dimension of the pyrometer viewing port controls a vertical temperature gradient within the physical vapor transport reactor,
a dimension of the cooling element controls an axial temperature gradient and a radial temperature gradient within the physical vapor transport reactor, and
a dimension of the thermal insulation controls an axial temperature gradient and a radial temperature gradient within the physical vapor transport reactor.
